# EUROPEAN PATENT APPLICATION

(11) **EP 2 562 293 A1**
(43) Date of publication of application: **27.02.2013**
(21) Application number: 11771760.3
(22) Date of filing: 20.04.2011
(51) Int. Cl.: C23F 11/00, C08K 5/07, C08K 5/098, C08K 5/521, C08L 101/00, C09D 7/12, C09D 183/04, C09K 3/10, H01L 23/29, H01L 23/31, H01L 33/56

(54) **SILVER ANTI-TARNISHING AGENT, SILVER ANTI-TARNISHING RESIN COMPOSITION, SILVER ANTI-TARNISHING METHOD, AND LIGHT-EMITTING DIODE USING SAME**

(30) Priority: 22.04.2010 JP 2010098444
(71) Applicant: Nippon Kayaku Kabushiki Kaisha, Tokyo 102-8172 (JP)
(72) Inventor: KAWATA, Yoshihiro, Tokyo 115-8588 (JP); SASAKI, Chie, Tokyo 115-8588 (JP); YARITA, Masato, Tokyo 115-8588 (JP); AOKI, Shizuka, Tokyo 115-8588 (JP); NAKANISHI, Masataka, Tokyo 115-8588 (JP)
(74) Representative: Gille Hrabal
(86) International application number: PCT/JP2011/002322
(87) International publication number: WO 2011/132419

(57) **Abstract**

The present invention relates to a silver anti-tarnish agent having, as an effective component, a zinc salt and/or a zinc complex, preferably at least one kind selected from the group consisting of a carboxylic acid zinc salt having a carbon atom number of 3 to 20, a phosphoric acid zinc salt, a phosphate ester zinc salt and a carbonyl compound zinc complex; a silver anti-tarnish method for preventing tarnish of a silver part by applying said silver anti-tarnish agent to the silver part. According to the present invention, tarnish of a silver part such as a silver-plated part due to a sulfur-based gas can be prevented. The present invention is useful particularly as a silver anti-tarnish agent for a light-emitting diode and allows preventing tarnish of a silver part of a light-emitting diode and reduction in illuminance by applying the silver anti-tarnish agent of the present invention to a silver part such as a silver-plated part of a light-emitting diode for covering the silver part.

## Description

### Technical Field

The present invention relates to an anti-tarnish agent of silver or a silver-plated part, particularly an anti-tarnish agent of silver or a silver-plated part used in a light-emitting diode; an anti-tarnish resin composition; an anti-tarnish method; and a light-emitting diode using this.

### Background Art

As a typical compound among organic zinc compounds, a compound called metal soap such as a fatty acid zinc compound (for example, zinc stearate) is known to be applied as a lubricant or a mold release agent for molding a synthetic resin and a tablet by taking advantage of its lubricating properties. In addition, an aromatic carboxylic acid zinc compound, for example, zinc benzoate is known to be applied as an anti-fungus agent which is due to its own characteristics (Patent Literature 1). As an application in common of the fatty acid zinc compound and the aromatic carboxylic acid zinc compound, a stabilizer for vinyl chloride resin film (Patent Literature 2), a condensation catalyst and a condensation accelerator for a condensation-type silicone resin (Patent Literature 3), and the like are known. Further, in recent years, application for rubber modification to reduce stickiness of a silicone rubber surface having a low hardness by bleeding-out on the top of an addition reaction-type silicone rubber (Patent Literature 4), and the like are known. However, it has not yet been known that these organic zinc compounds themselves have silver anti-tarnish effect, particularly anti-tarnish effect of a silver-plated part used for a light-emitting diode.

In many cases, for a light-emitting diode, a lead frame is arranged around or underneath the chip in order to supply current to the diode chip. For that reason, in order to effectively utilize light emitted from the chip, the lead frame itself is required to use a metal having a high reflectance or to be plated with the metal. Above all, silver has a high reflectance to visible light rays, so it is used as a plating material for a lead frame for a light-emitting diode in many cases.
However, silver is known to be a material which is generally easily deteriorated, and particularly highly reactive to the sulfur element to become silver sulfide and turn black. For that reason, it has been generally used after sealing with an epoxy resin and the like for the purpose of protecting a lead frame from sulfur-based gases and the like which tarnish silver. In fact, a light-emitting diode sealed with an epoxy resin is capable of retarding silver tarnish and has not been a problem on the market.

In recent years, there has been developed a product of a light-emitting diode emitting a light with a short wavelength around 460 nm and the luminance has further become higher, resulting in generation of more heat during emission. It has been found that the sealing resin itself of a sealing material using a conventional epoxy resin is colored under the influence of light with the short wavelength and heat so cannot be used. For that reason, recently, a silicone resin with a strong resistance to light and heat (of soft rubber type or hard resin type) is more often employed as a sealing material. However, the silicone resin has very high gas permeability compared with the epoxy resin and allows easy permeabilization of sulfur-based gases that cause tarnishing of the above silver. Said permeabilized gases tarnish a silver-plated part of a sealed-inside and the like, so the reflectance of the silver-plated part is reduced. As the result, the illuminance is reduced. For that reason, as a problematic point with silicone resin sealing of a silver-plated frame, reduction in durability is pointed out in this term. The market is in a situation of having to accept the transition to a chemically stable gold plate in order to avoid silver tarnish and ensure reliability. However, the price of gold is high compared with that of silver, and thus gold is expensive and has a disadvantage in aspect of economic efficiency, and in addition, above all, altering to the gold-plated has an important problem leading to large reduction in light reflectance (also mentioned as up to several dozen %). A technique is desired which prevents silver tarnish and ensures reflectance durability even when a silicone resin is used as a sealing material.

### Related Technical Literature

### [Patent Literature]

[Patent Literature 1] Japan Patent No. 2772445
[Patent Literature 2] Japan Patent No. 3385578
[Patent Literature 3] Japanese Patent Laid-Open No. 2008-274272 A
[Patent Literature 4] Japanese Patent Laid-Open No. 2010-043136 A

### Summary of the Invention

### Problems to Be Solved by the Invention

It is an object of the present invention to provide a silver anti-tarnish agent capable of exerting and maintaining anti-tarnish effect on a silver surface of silver plates and the like, particularly on a silver-plated part used in a light-emitting diode on which a sulfur-based gas affects; an anti-tarnish resin composition; and an anti-tarnish method.

### Means of Solving the Problems

The present inventors have intensively studied in view of the above actual situation and found that a zinc compound, particularly a zinc salt or a zinc complex is effective to prevent silver tarnish, and thus the present invention has been completed. That is, the present invention relates to the following (1) to (25):
(1) Use of a zinc salt or a zinc complex for manufacturing a silver anti-tarnish agent containing at least either a zinc salt or a zinc complex as an effective component.
(2) The use according to (1), wherein the silver anti-tarnish agent is a silver anti-tarnish agent for a light-emitting diode.
(3) The use according to (1) or (2), wherein the silver anti-tarnish agent is a silver anti-tarnish agent containing at least one kind selected from the group consisting of a carboxylic acid compound zinc salt having a carbon atom number of 3 to 20, a phosphoric acid zinc salt, a phosphate ester zinc salt and a carbonyl compound zinc complex, as an effective component.
(4) The use according to any one of (1) to (3), wherein the silver anti-tarnish agent is a silver anti-tarnish agent containing an aliphatic carboxylic acid zinc salt having a carbon atom number of 3 to 20 as an effective component.
(5) The use according to (4), wherein said aliphatic carboxylic acid zinc salt is a saturated or unsaturated fatty acid zinc salt.
(6) The use according to (5), wherein said aliphatic carboxylic acid zinc salt is at least one kind selected from the group consisting of zinc 2-ethylhexylate, zinc neodecanoate, zinc laurate, zinc ricinoleate, zinc stearate, zinc undecylenate and zinc naphthenate.
(7) The use according to (4) or (5), wherein said aliphatic carboxylic acid zinc salt is a zinc salt of an alicyclic carboxylic acid having at least either a cyclopentane or cyclohexane skeleton.

(8) The use according to any one of (1) to (7), wherein the silver anti-tarnish agent is a silver anti-tarnish agent containing a zinc salt of a phosphate ester and/or a phosphoric acid as an effective component.
(9) The use according to any one of (1) to (8), wherein the silver anti-tarnish agent is a silver anti-tarnish agent containing a zinc acetylacetonate complex as an effective component.
(10) The use according to any one of (1) to (9), wherein the silver anti-tarnish agent further contains a solvent, and contains 0.005 to 1 % by weight of at least either a zinc salt or a zinc complex as an effective component in said solvent.
(11) A silver anti-tarnish resin composition for a light-emitting diode, which contains at least either a zinc salt or a zinc complex and a sealing resin, said at least either a zinc salt or a zinc complex being contained in an amount of 0.05 to 10 parts by weight based on 100 parts by weight of said resin.
(12) The silver anti-tarnish resin composition according to (11), wherein a cured product of the resin composition has a hardness of over 70 as measured by Durometer Type A of JIS K 7215.
(13) The silver anti-tarnish resin composition according to (11) or (12), wherein the cured product of the resin composition has a refractive index of over 1.45.
(14) The silver anti-tarnish resin composition according to any one of (11) to (13), wherein the sealing resin is a sealing resin containing a silicone skeleton.
(15) A silver anti-tarnish method, wherein the silver anti-tarnish agent according to any one of (1) to (10) is applied to a silver surface.
(16) The silver anti-tarnish method according to (15), the silver surface is a silver surface of a light-emitting diode.

(17) The silver anti-tarnish method according to (15) or (16), wherein the silver anti-tarnish agent according to the above-described (1) further contains a solvent, and contains 0.005 to 1% by weight of at least either a zinc salt or a zinc complex as an effective component in said solvent.
(18) A silver anti-tarnish method, wherein the silver anti-tarnish resin composition according to any one of (11) to (14) is applied to a silver surface of a light-emitting diode.
(19) A light-emitting diode having, on the silver surface, a dried film or a cured product coat of a silver anti-tarnish agent containing at least either a zinc salt or a zinc complex.
(20) The light-emitting diode according to the above-described (19), which is sealed with a sealing resin on the dried film or the cured product coat of the silver anti-tarnish agent.
(21) A light-emitting diode having a silver surface sealed with the silver anti-tarnish resin composition according to any one of (11) to (14).
(22) The light-emitting diode according to (19) or (20), the sealing resin is a silicone resin which is curable by addition reaction and after curing forms a cured product having a hardness of over 70 as measured by Durometer Type A of JIS K 7215 after curing.
(23) A silver anti-tarnish agent containing at least either a zinc salt or a zinc complex as an effective component, said effective component being contained in a ratio of 0.005 to 1 part by weight based on 100 parts by weight of a diluent.
(24) The silver anti-tarnish agent according to (23), wherein the diluent is an organic solvent.
(25) The silver anti-tarnish agent according to (23), wherein the diluent is a silicone resin.

### Effect of the Invention

When a silver part of a product using silver is covered with the silver anti-tarnish agent according to the present invention, tarnish of a silver part by hydrogen sulfide and the like can be prevented over a long period of time. For example, when the surface of a silver part of a light-emitting diode or the like having a silver-plated part is covered with the silver anti-tarnish agent according to the present invention, specifically, when it is covered with a dried coat or a resin cured product of said silver anti-tarnish agent, tarnish of the silver part of said light-emitting diode is not observed for a long period of time even in severe test in the presence of hydrogen sulfide, and thus reduction in illuminance of a light-emitting diode can be prevented. In addition, a similar effect can be achieved on a light-emitting diode sealed with the silver anti-tarnish resin composition of the present invention. Therefore, according to the present invention, even using a silicone resin allowing permeabilization of a gas that causes silver tarnish, such as hydrogen sulfide, as a sealing resin has an advantage of obtaining a light-emitting diode having no reduction in illuminance and being excellent in durability.

### Mode for Carrying Out the Invention

The present invention is characterized by using a zinc salt and/or a zinc complex as an effective component of a silver anti-tarnish agent. The present invention is useful for anti-tarnish of a silver part of a product using silver, particularly useful for anti-tarnish of a reflective silver-plated part in a light-emitting diode. In the present invention, the mechanisms to prevent said silver tarnish is not clear, but it is considered that silver tarnish is prevented in that the zinc salt or the zinc complex reacts with or physically absorbs a compound that causes tarnishing of silver, for example, hydrogen sulfide and the like, or such acts to prevent a sulfide gas from reaching the silver part.

As an effective component of the silver anti-tarnish agent in the present invention, any of a zinc salt and/or a zinc complex (hereinafter, also referred to as said zinc compound in some cases) can be used. The zinc salt and/or the zinc complex is preferably a compound which is a salt with an organic acid or a phosphoric acid compound and/or a complex with an organic compound, with a zinc ion or a zinc atom being as a central element, and which has at least one kind selected from the group consisting of a carboxylic acid compound, phosphate ester, phosphoric acid and a carbonyl compound or has an ion of said compound, as a counter ion or a ligand.
The above-described carboxylic acid compound can include, for example, a carboxylic acid compound having a carbon atom number of 3 to 20. Said carboxylic acid compound having a carbon atom number of 3 to 20 can include an aliphatic carboxylic acid. More specifically, it can include an aliphatic carboxylic acid having a carbon atom number of 3 to 20, such as saturated fatty acid having a carbon atom number of 3 to 20, unsaturated fatty acid having a carbon atom number of 3 to 20 and alicyclic carboxylic acid having a carbon atom number of 5 to 9. Among them, it is a carboxylic acid compound having a carbon atom number of preferably 6 to 20 and more preferably of 6 to 18, in consideration of compatibility with a resin. In addition, it is preferably a carboxylic acid compound having a carbon atom number of 7 to 17 in some cases. Said carboxylic acid compound is usually preferably an aliphatic carboxylic acid. The above-described aliphatic carboxylic acid having a carbon atom number of 3 to 20 may be any of chain or cyclic. It is more preferably an aliphatic carboxylic acid having a carbon atom number of 6 to 20 and more preferably of 6 to 18. The carbon chain in said chain aliphatic carboxylic acid may be straight-chain or branched. Further, usually, the saturated aliphatic carboxylic acid is preferable.
A preferable zinc salt of a carboxylic acid compound can include a zinc salt of the above-described carboxylic acid compound. More specifically, it is preferably a zinc salt of an aliphatic carboxylic acid having a carbon atom number of 3 to 20, more preferably a zinc salt of an aliphatic carboxylic acid having a carbon atom number of 6 to 20 and further preferably a zinc salt of an aliphatic carboxylic acid having a carbon atom number of 6 to 18.

The zinc salt of a saturated aliphatic carboxylic acid having a carbon atom number of 6 to 20 can specifically include zinc 2-ethylhexylate (zinc octylate), zinc neodecanoate, zinc laurate, zinc ricinoleate, zinc stearate, zinc undecylenate, zinc naphthenate (carboxylic acid with main components of cyclopentane and cyclohexane) and the like, and they are preferable in viewpoint of compatibility with resin. More preferably, it is zinc 2-ethylhexylate (zinc octylate), zinc undecylenate, zinc naphthenate or zinc stearate, further preferably zinc 2-ethylhexylate or zinc stearate and most preferably zinc 2-ethylhexylate.
The alicyclic carboxylic acid zinc salt can include an alicyclic carboxylic acid zinc salt having a carbon atom number of 5 to 9, and it includes, for example, a zinc salt of an alicyclic carboxylic acid having a cyclopentane and/or cyclohexane skeleton such as cyclopentane carboxylic acid or cyclohexane carboxylic acid, and it can specifically include zinc naphthenate.
In the present invention, one of the most preferable zinc salts is zinc 2-ethylhexylate.

The phosphate ester includes monoalkyl ester, dialkyl ester and trialkyl ester, and in the above, the alkyl group includes a C1 to C20 alkyl group such as a methyl group, an isopropyl group, a butyl group, a 2-ethylhexyl group, an octyl group, an isodecyl group, an isostearyl group, a decanyl group and a cetyl group and it is preferably a C6 to C20 alkyl group. Among them, the type of the 2-ethylhexyl group is liquid and it is more preferable in consideration of workability.
The carbonyl compound in the present invention is a carbonyl group-containing compound forming a complex with zinc, other than an aliphatic carboxylic acid compound forming the above-described zinc salt, and can include, for example, acetylacetone. Said complex is preferably zinc acetylacetonate with 2,4-pentadione being a ligand.
Other zinc salts and/or zinc complexes include zinc benzoate, zinc p-tert-butyl benzoate, zinc phenolsulfonate, zinc (II) = dioctanoate, zinc diethyl, zinc cyanide, zinc borate, zinc (II) = didodecanoate, zinc phthalate, zinc carbonate, zinc gluconate, zinc methacrylate, 8-hydroxyquinoline zinc complex salt, zinc aminoacetate (for example glycine zinc chelate compound), zinc alkyl(C4 to 12)benzoate, zinc bromoacetate and the like.
These zinc compounds can be used as a liquid to solid one, and a mixture of one kind or two or more kinds thereof can also exert anti-tarnish effect on silver.
Preferable zinc salts and/or zinc complexes can include a zinc salt of an aliphatic carboxylic acid having a carbon atom number of 6 to 20, a zinc salt of a phosphoric acid C6 to C20 alkyl ester or a zinc complex with a carbonyl compound. The zinc complex with a carbonyl compound is preferably zinc acetylacetonate.

The silver anti-tarnish agent of the present invention may be said effective component alone or as a mixture of said effective component and a diluent (for example, with a solvent, a resin or the like), as long as a zinc salt and/or a zinc complex is the effective component. Usually in terms of convenience in use, it is used as a composition containing said effective component and a diluent. In the case of said silver anti-tarnish agent containing said diluent, the effective component concentration is not particularly limited. Usually, for convenience in use, it is preferably a concentration which can be used as it is. For the concentration which can be used as it is, the ratio is that the effective component is preferably 0.005 parts by weight or more, usually about 0.005 to 10 parts by weight and preferably about 0.005 to 1 part by weight, based on 100 parts by weight of the diluent.
As the above-described diluent, any organic solvent or resin can be used as long as it is capable of covering a silver surface. Said resin is preferably a curable resin in the case of using for a light-emitting diode or the like. As the curable resin, any resin can be used as long as it is cured after covering a silver surface. Usually, a resin (sealing resin) which can be used for sealing a light-emitting diode is preferable.

The silver anti-tarnish agent of the present invention can exert the effect more effectively by existing a zinc salt and/or a zinc complex on a silver surface. The silver capable of obtaining anti-tarnish effect with the silver anti-tarnish agent of the present invention may be a pure silver or may be a silver-plated or -alloy form as long as the silver is deteriorated by sulfur elements.
It is preferable that a zinc salt and/or a zinc complex exists all over the silver surface. Usually, it is preferable that said zinc salt and/or zinc complex exists in a film state or the like to cover the silver surface. In this regard, in the case where the effective component compound of the present invention is dissolved in a solvent before use, only the effective component exists after drying, and in this case, it is doubtful whether the effective component is surely in a film state, but in the present invention, it is regarded for convenience as in a film state in such a case.
In addition, in the case of a light-emitting diode or the like, the silver surface can be covered with a zinc salt and/or a zinc complex by sealing the silver surface with a sealing resin containing said zinc salt and/or zinc complex.
A preferable aspect of the silver anti-tarnish agent of the present invention can include an aspect in which either or both of a zinc salt or a zinc complex as an effective component and a diluent are contained, and said effective component is contained in a ratio of 0.005 to 10 parts by weight, preferably 0.005 to 3 parts by weight, more preferably 0.005 to 2 parts by weight and further preferably 0.005 to 1 part by weight, based on 100 parts by weight of the diluent.
Further, in the above-described, one of further preferable aspects can include an aspect in which the diluent is an organic solvent dissolving said effective component and said silver anti-tarnish agent is a composition which is liquid at ordinary temperature, or an aspect in which the diluent is a resin (according to necessity, an organic solvent or the like dissolving a resin and said effective component may further contained) and said silver anti-tarnish agent is a resin composition, preferably a resin composition which is liquid at ordinary temperature.

Treatment with the silver anti-tarnish agent of the present invention can be carried out as follows.
That is, it can be carried out in that said zinc salt and/or zinc complex as an effective component or the silver anti-tarnish agent of the present invention is, according to necessity, diluted (preferably dissolved) with a diluent such as a suitable solvent to give a solution having a suitable treatment concentration, which is then applied to an intended silver surface so that the silver surface is covered with said effective component or silver anti-tarnish agent. The silver surface can include a surface of silver-plated parts, silver-using parts of chips or various molded articles, and the like. As an applying method, any method has no problem as long as it can cover an intended silver surface. It can include, for example, a method in which atomization, coating or dropwise-addition or the like is performed using a spray, dispenser or the like, or a method in which an intended product for preventing tarnish is immersed in a treatment liquid containing said silver anti-tarnish agent, or a method in which a silver surface is sealed or such with a resin composition containing a zinc salt and/or a zinc complex, or the like. In this regard, the silver anti-tarnish agent of the present invention can be applied to any silver, which may be pure silver, an alloy containing silver, or the like.

The solvent to dissolve said zinc salt and/or zinc complex as an effective component or to be used as a diluent for the silver anti-tarnish agent of the present invention can include an organic solvent and water, and it is preferably an organic solvent dissolving said effective component. The organic solvent includes an organic solvent which can be usually used, for example, alcohols such as methanol, ethanol and isopropanol, ketones such as acetone, methyl ethyl ketone, methyl isobutyl ketone and cyclopentanone, hydrocarbon solvents such as toluene, xylene, hexane, cyclohexane and cyclopentane, halogenated hydrocarbon solvents such as chloromethane, dichloroethane, chloroform and carbon tetrachloride, esters such as methyl acetate and ethyl acetate, ethers such as diethyl ether and tetrahydrofuran, amides such as N,N-dimethylformamide, and the like, and these solvents may be used in combination of two or more kinds. In terms of solubility, easy treatment, environmental problems and the like, a ketone solvent is generally preferable. In addition, as a diluent, a silicone resin which is liquid and cured by addition reaction is also preferable.

The use concentration of the zinc salt and/or the zinc complex in a solvent can be appropriately set. Usually, the concentration based on the total amount of the solvent may be 0.005% by weight or more, preferably 0.005% by weight to 1% by weight, further preferably 0.005 to 0.5% by weight, and most preferably 0.01% by weight to 0.5% by weight.
In the case of treating with too low concentration, much anti-tarnish effect on silver over a long period of time cannot be expected. On the other hand, in the case of treating with too high concentration, contact with a sulfur-based gas leads to easy coloring, resulting in adverse effects. The treatment temperature can be appropriately determined. For example, application to a silver surface is carried out at ordinary temperature, and then according to necessity, drying or resin-curing can be carried out.
Specifically, for example, in the case of using an organic solvent as a diluent, the silver anti-tarnish agent of the present invention is applied to a silver surface, and then drying may appropriately carried out at usually room temperature to 200°C, preferably 50°C to 150°C and more preferably 50°C to 120°C or less. If the drying temperature is too low, the organic solvent possibly remains and inconvenience is likely to occur in a later process. For example, in the case of sealing with the silver anti-tarnish agent (resin composition) of the present invention containing a solvent and a resin as a diluent for a light-emitting diode or the like, if drying is insufficient, it is possible that the organic solvent remaining as foam gives deficiency in curing said sealing resin. On the other hand, if the drying temperature is too high, it is feared that coloring and oxidation of various parts are caused and performance of the light-emitting diode is degraded in the initial stage.

If a silver product is left in the air during a manufacturing process, the surface usually becomes darkened, so when there is a stop during the manufacturing process, there occurs necessity of keeping in a repository such as a desiccator. However, when the surface of a molded article made from a silver plate or silver is treated with the silver anti-tarnish agent of the present invention, the product can be kept in a state during the manufacturing process for a long period of time, resulting in contribution to streamlining of the manufacturing process. For example, silver-tarnish does not occur on a light-emitting diode with the silver surface covered with the silver anti-tarnish agent of the present invention, even during the manufacturing process before sealing and even without keeping in a desiccator.

In addition, in the present invention, it is possible to provide a generally usable light-emitting diode by covering silver with said silver anti-tarnish agent and then by adding dropwise, infusing and/or coating a sealing resin in order to physically protect the light-emitting diode, followed by curing the sealing resin.
Said sealing resin which can be used is not particularly limited as long as it is a resin which can be used for the sealing part of a light-emitting diode. For example, it can include a thermoplastic resin, a thermosetting resin and the like. Specifically, the following resins can be exemplified.

For example, the sealing resin can include a silicone resin, an epoxy-based resin, polyethylene, polypropylene, polybutylene and their copolymers, a polyolefin-based resin such as cyclopolyolefin, an alkyd-based resin, a guanamine-based resin, a phenol-based resin, a fluorine plastic-based resin such as tetrafluoroethylene (PTFE) and fluorinated ethylene polypropylene copolymer (FEP), a polyacrylonitrile-based resin, a polystyrene-based resin, a polyacetal-based resin, a polyamide-based resin such as nylons 6, 11, 12, 46, 66, 610, 612 and their copolymers, a (meth)acrylic acid ester-based resin such as polymethyl acrylate, polymethyl methacrylate and ethylene-ethyl acrylate copolymers, a polyimide-based resin such as thermoplastic polyimide and polyetherimide, a polyetheretherketone-based resin, a polyethylene oxide-based resin, a polyester-based resin such as polyethylene terephthalate (PET), polybutylene terephthalate (PBT) and their copolymers, a polyvinyl acetate-based resin, a polyvinyl alcohol-based resin, a polyvinyl ether-based resin, a polyphenylene ether-based resin, a polyphenylene oxide-based resin, a polymethylpentene-based resin, a polyurethane-based resin, a melamine-based resin, a urea-based resin, a polycarbonate-based resin, a furan-based resin, a silicon-based resin, an ionomer-based resin, a polyisocyanate-based resin, polyterpene-based resin, and their copolymers, and the like.

Among these, a silicone resin, an epoxy-based resin, a cyclopolyolefin-based resin, a polyacrylonitrile-based resin, a polystyrene-based resin, a polyamide-based resin, a (meth)acrylic acid ester-based resin, a polyetheretherketone-based resin, a polyester-based resin, a polycarbonate-based resin, and their copolymers are preferable, and they may be a resin modified to impart certain properties. In addition, these resins can be used alone or as a blend of two or more kinds thereof.
Particularly in order to impart solder reflow resistance to a light-emitting diode, it is preferable to use at least a thermosetting resin in the sealing resin.

The thermosetting resin is preferably one containing an epoxy resin and/or silicone resin component. Particularly, the epoxy resin is preferably a cyclohexyl-type epoxy resin excellent in light fastness. The silicone resin can be selected from ones exhibiting rubber elasticity after curing and hard resin types. In addition, it can be selected among silicone resins of addition polymerization-type by addition reaction of a hydrosilyl group (Si-H) with a unsaturated double bond and of condensation polymerization-type by condensation reaction of a silanol group, an alkoxy group or the like. Particularly among them, it is preferably a silicone resin of addition polymerization-type not involving gas generation during the reaction.

As the silicone resin, any silicone resin can be used as long as it is used for sealing a light-emitting diode. It can be selected from a dimethyl silicone resin mainly having a methyl group in the main skeleton and a phenylmethyl silicone resin mainly having a phenyl group in the main skeleton. The silicone resin of addition polymerization-type is preferably a silicone resin disclosed in, for example, Japanese Patent Laid-Open No. 2004-186168, Japanese Patent Laid-Open No. 2007-63538, and the like. Particularly preferable is a phenylmethyl silicone resin of addition polymerization-type.
The silicone resin of addition polymerization-type is a silicone resin containing an organopolysiloxane having an alkenyl group (preferably, a C2 or C3 alkenyl group, and more preferably a vinyl group). More in detail, it is a silicone resin containing an organopolysiloxane (A component) having at least two alkenyl groups (preferably a C2 or C3 alkenyl group, and more specifically a vinyl or allyl group) which bond to the silicon atom and containing an organohydrogenpolysiloxane (B component) having at least two hydrogen atoms which addition-polymerize with the alkenyl group and bond to the silicon atom. Said silicone resin, usually, further contains an addition reaction catalyst and may further contain an arbitrary additive.

The organo group other than the above-described alkenyl group in the above-described A or B component includes an aromatic group such as a phenyl group or a naphthyl group, a C1 to C6 saturated aliphatic group, and the like. Said C1 to C6 saturated aliphatic group can include a C1 to C4 alkyl group such as a methyl group, an ethyl group, a propyl group and a butyl group, a cyclic aliphatic group such as a cyclohexyl group, and the like. In the present invention, said organo group is preferably a silicone resin containing an organopolysiloxane having both (1) a C1 to C4 alkyl group (more preferably a methyl group) and (2) at least one group selected from the group consisting of a phenyl group, a naphthyl group and a cyclohexyl group, and more preferably a silicone resin containing an organopolysiloxane having a phenyl group and a methyl group.
In addition, as an arbitrary additive, an organopolysiloxane containing a functional group such as an epoxy group (for example a glycidyl group, an epoxycyclohexyl group or the like) may be contained. The above-described alkenyl group may be contained in only A component or in both A component and B component. In the present invention, it is preferable that the alkenyl group is contained in the both. A preferable silicone resin is a silicone resin where A component is an organopolysiloxane having, as an organo group, (1) an alkenyl group, (2) at least one kind of phenyl group, naphthyl group or cyclohexyl group and more preferably phenyl group, and (3) a C1 to C4 alkyl group and preferably a methyl group, and B component is an organohydrogenpolysiloxane having, as an organo group, (1) at least one kind of phenyl group, naphthyl group or cyclohexyl group and more preferably phenyl group and (2) a C1 to C4 alkyl group (preferably, a methyl group), more preferably an organohydrogenpolysiloxane having (1) an alkenyl group, (2) at least one kind of phenyl group, naphthyl group or cyclohexyl group and more preferably phenyl group and (3) a C1 to C4 alkyl group (preferably a methyl group), and further preferably an organohydrogenpolysiloxane having (1) an alkenyl group, (2) a phenyl group and (3) a C1 to C4 alkyl group (preferably a methyl group). More preferably, in the above-described, it is a phenylmethyl silicone resin where the alkenyl group is a vinyl group and the C1 to C4 alkyl group is a methyl group.

The ratio of the above-described organo group can be arbitrarily selected. Preferable examples of the approximate ratio range are as described below.
The mole ratio of each component of the above (1) to (3) in the organopolysiloxane of A component is in the range where, for example, when the alkenyl group of (1) is 1 mol, the phenyl group or the like of (2) is 0.1 to 60 mol, preferably 0.2 to 50 mol and more preferably 0.2 to 40 mol, and the C1 to C4 alkyl group of (3) is 0.1 to 60 mol, preferably 0.5 to 50 mol and more preferably 1 to 40 mol.
In addition, in the case of the organohydrogenpolysiloxane of B component, when the mole number of the hydrogen atom bonding to the silicon atom is 1 mol, the alkenyl group is 0 to 5 mol, preferably 0 to 3 mol, more preferably 0.1 to 3 mol and further preferably 0.5 to 3 mol, the phenyl group or the like of the above (1) is 0.5 to 30 mol, preferably 0.5 to 20 mol, more preferably 1 to 20 mol and further preferably 1 to 10 mol, and the C1 to C4 alkyl group of the above (2) is 0.5 to 30 mol, preferably 0.5 to 20 mol, more preferably 1 to 20 mol and further preferably 1 to 10 mol.
The above-described addition reaction-type silicone resin is described in the above-described published applications and the like, and a generally known one can be used. Also, a commercial product can be purchased.

For the ratio of the organopolysiloxane (A component) having an alkenyl group and the organohydrogenpolysiloxane (B component), usually based on 1 mol of the alkenyl group bonding to the silicon atom of A component (based on 1 mol of the alkenyl group bonding to the silicon atoms of A component and B component, in the case of containing an alkenyl group in B component, too), the mole number of the hydrogen atom bonding to the silicon atom of B component is 0.5 to 5 mol, preferably 0.5 to 4 mol and more preferably 0.5 to 3 mol.
As an addition reaction catalyst, a platinum group catalyst is usually used, and more preferable is a platinum catalyst.
For example, a platinum group metal catalyst includes a platinum catalyst such as platinum black, platinum II chloride, chloroplatinic acid, a reaction product of chloroplatinic acid with a monovalent alcohol, a complex of chloroplatinic acid and an olefin and platinum bisacetoacetate, a palladium catalyst, a rhodium catalyst and the like. In this regard, the mixing amount of this addition reaction catalyst may be a catalytic amount and the reaction catalyst is preferably mixed usually as a platinum group metal in an amount of 1 to 500 ppm and particularly about 2 to 100 ppm based on the total weight of A and B components.
In addition, in order to ensure the silver anti-tarnish effect of the present invention, it is preferable to use a sealing resin having a hardness of over 70 as measured by Durometer Type A after curing the sealing resin. A more preferable hardness after curing is in the range that the hardness as measured by Durometer Type A is over 70 and the hardness as measured by Durometer Type D is about 20 to 70 and more preferably about 30 to 70. For hardness measurement by Durometer, the hardness of a relatively soft resin is measured by Type A and the hardness of a relatively hard resin is measured by Type D. It is general to measure by Type D when the hardness measured by Type A is 90 or more. In this regard, in the present invention, when a sealing resin having too low hardness after curing is used, handling of the light-emitting diode is difficult due to stickiness of the sealing resin surface after sealing. On the other hand, too high hardness after curing easily causes occurrence of cracking after sealing, during use, or the like, resulting in lack of reliability.

In addition, in the present invention, it is preferable to use a resin having a high refractive index as a sealing resin. Because a high refractive index of sealing resin leads to high efficiency of taking out light from the light-emitting diode, it is possible to prevent reduction in illuminance due to silver anti-tarnish and obtain a light-emitting diode having a higher illuminance by using a sealing resin having a high refractive index. The refractive index of a preferable sealing resin is 1.45 or more and more preferably 1.49 or more. The upper limit is usually about 1.6 or less.

Next, one of the aspects of the silver anti-tarnish agent of the present invention can include an aspect in which it is used as a silver anti-tarnish resin composition using a sealing resin as a diluent.
Hereinafter, this silver anti-tarnish resin composition will be explained.
In the present invention, by using, as a diluent, a resin used for covering or sealing said silver part (hereinafter referred to as sealing resin for simplicity) for the purpose of protecting the silver part from physical impact and the like from outside, the silver anti-tarnish agent can be also used as a silver anti-tarnish resin composition. In this case, by beforehand adding the zinc salt or the zinc complex as the effective component of the present invention into said sealing resin so that the above use concentration is given for use as a usual sealing resin, silver part-tarnish can be prevented.
Said sealing resin can include the resins explained in the paragraph of the sealing resin described above. Among the above sealing resins, a sealing resin containing an epoxy and/or silicone resin component (silicone resin) is preferable. In terms that the effects of the present invention can be particularly exerted, a silicone resin is more preferable. As said silicone resin, silicone resins listed as preferable ones in the paragraph of the sealing resin are preferable. Most preferable is a phenylmethyl silicone resin which is cured by addition reaction.

In adding the zinc salt and/or the zinc complex to the sealing resin, it is necessary that the addition is carried out to the extent that the properties of the sealing resin are not reduced. That is, when an effective component amount of said zinc compound is mixed with a resin, it is desired not to reduce properties such as light quantity, heat resistance and light fastness, in the sealing resin of the light-emitting diode. For the addition amount of these to the sealing resin, as well as mentioned above in the paragraph of the diluent, said zinc salt and/or zinc complex of the present invention is 0.05 to 10 parts by weight, preferably 0.05 to 4 parts by weight, more preferably 0.1 to 2 parts by weight and particularly preferably about 0.1 to 1 part by weight, based on 100 parts by weight (the total amount) of the sealing resin. If said addition amount is too small, the effects are not sufficiently exerted, and if it is too large, coloring occurs to the sealing resin and emitting light is absorbed, resulting in that luminescence intensity (light quantity) is, by contrary, reduced in some cases. In this regard, in the present invention, other than addition of the zinc compound to a sealing resin, there is also a use method where it is added to a coating composition, and the method does not matter.

The silver anti-tarnish resin composition of the present invention, according to necessity, can be mixed with various additives in the range that the effects of the present invention are not impaired. For example, an inorganic filler as a reinforcing and/or scattering agent, a phosphor, an antioxidant, a light stabilizer, a cross-linking auxiliary agent, a mold-release agent, an ultraviolet absorbing agent, a processing auxiliary agent, a colorant and other additives can be mixed.

The inorganic filler includes powders of crystalline silica, molten silica, alumina, zircon, calcium silicate, calcium carbonate, silicon carbide, silicon nitride, boron nitride, zirconia, forsterite, steatite, spinel, titania, talc and the like, or spheronized beads and the like thereof, but it is not limited thereto. These may be used alone or in combination of two or more kinds thereof. When these inorganic fillers are used, they are used in an amount accounting for 0.5% by weight to 95% by weight in the resin composition. When an inorganic filler is used for the purpose of scattering, it is preferable to use one having a particle size of 200 nm or more and the content is preferably 0.5% by weight to 50% by weight. In the other hand, when it is not used for the purpose of scattering, it is preferable that one having a particle size 200 nm or less is used and the content is 0.5% by weight to 30% by weight.

The phosphor has an action to form white light, for example, by absorbing some of blue light emitted from a blue LED device and by emitting yellow light with a converted wavelength. The phosphor is beforehand dispersed in a curable resin composition and then an optical semiconductor is sealed therewith. The phosphor is not particularly limited, a conventionally known phosphor can be used, and for example, aluminate, thiogallate and orthosilicate of rare earth elements are exemplified. More specifically, it includes a phosphor such as YAG phosphor, TAG phosphor, orthosilicate phosphor, thiogallate phosphor and sulfide phosphor, exemplifying YAIO₃:Ce, Y₃Al₅O₁₂:Ce, Y₄Al₂O₉:Ce, Y₂O₂S:Eu, Sr₅(PO₄)₃Cl:Eu, (SrEu)O·Al₂O₃ and the like. For the particle size of such a phosphor, a particle size known in this field is used, and the average particle size is 1 to 250 µm and particularly 2 to 50 µm is preferable. When these phosphors are used, the addition amount is 1 to 80 parts by weight and preferably 5 to 60 parts by weight based on 100 parts by weight of the resin component.

The antioxidant includes phenol-based, sulfur-based and phosphorus-based antioxidants. The antioxidants can be used alone or in combination of two or more kinds thereof. The use amount of the antioxidant is usually 0.008 to 1 part by weight and preferably 0.01 to 0.5 part by weight based on 100 parts by weight of the resin in the resin composition of the present invention. The antioxidant includes, for example, a phenol-based antioxidant, a sulfur-based antioxidant, a phosphorus-based antioxidant and the like.

As specific examples of the phenol-based antioxidant, mono phenols such as 2,6-di-t-butyl-p-cresol, butylated hydroxyanisole, 2,6-di-t-butyl-p-ethylphenol,
stearyl-beta-(3,5-di-t-butyl-4-hydroxyphenyl)propionate,
isooctyl-3-(3,5-di-t-butyl-4-hydroxyphenyl)propionate,
2,4-bis-(n-octylthio)-6-(4-hydroxy-3,5-di-t-butylanilino)-1,3,5-triazine and 2,4-bis[(octylthio)methyl]-o-cresol; bisphenols such as 2,2' -methylene bis(4-methyl-6-t-butylphenol), 2,2' -methylene bis(4-ethyl-6-t-butylphenol), 4,4' -thio bis(3-methyl-6-t-butylphenol), 4,4' -butylidene bis(3-methyl-6-t-butylphenol), triethylene glycol-bis[3-(3-t-butyl-5-methyl-4-hydroxyphenyl)propionate],
1,6-hexanediol-bis[3-(3,5-di-t-butyl-4-hydroxyphenyl)propionate], N,N' -hexamethylene bis(3,5-di-t-butyl-4-hydroxy-hydrocinnamamide), 2,2-thio-diethylene bis[3-(3,5-di-t-butyl-4-hydroxyphenyl)propionate],
3,5-di-t-butyl-4-hydroxybenzylphosphonate-diethyl ester,
3,9-bis[1,1-dimethyl-2-{beta-(3-t-butyl-4-hydroxy-5-methylphenyl)propionyloxy}ethyl]2,4, 8,10-tetraoxaspiro[5,5]undecane, bis(3,5-di-t-butyl-4-hydroxybenzyl sulfonic acid ethyl)calcium; and high-molecular phenols such as 1,1,3-tris(2-methyl-4-hydroxy-5-t-butylphenyl)butane,
1,3,5-trimethyl-2,4,6-tris(3,5-di-t-butyl-4-hydroxybenzyl)benzene,
tetrakis-[methylene-3-(3' ,5' -di-t-butyl-4' -hydroxyphenyl)propionate]methane, bis[3,3' -bis-(4' -hydroxy-3' -t-butylphenyl)butyric acid]glycol ester, tris-(3,5-di-t-butyl-4-hydroxybenzyl)-isocyanurate,
1,3,5-tris(3' ,5' -di-t-butyl-4' -hydroxybenzyl)-S-triazine-2,4,6-(1H,3H,5H)trione and tocophenol are exemplified.

As specific examples of the sulfur-based antioxidant, dilauryl-3,3' -thiodipropionate, dimyristyl-3,3' -thiodipropionate, distearyl-3,3' -thiodipropionate and the like are exemplified.
As specific examples of the phosphorus-based antioxidant, phosphites such as triphenyl phosphite, diphenylisodecyl phosphite, phenyldiisodecyl phosphite, tris(nonylphenyl)phosphite, diisodecyl pentaerythritol phosphite, tris(2,4-di-t-butylphenyl)phosphite, cyclic neopentanetetrayl bis(octadecyl)phosphite, cyclic neopentanetetrayl bis(2,4-di-t-butylphenyl)phosphite, cyclic neopentanetetrayl bis(2,4-di-t-butyl-4-methylphenyl)phosphite and bis[2-t-butyl-6-methyl-4-{2-(octadecyloxycarbonyl)ethyl}phenyl]hydrogen phosphite; oxaphosphaphenanthrene oxides such as 9,10-dihydro-9-oxa-10-phosphaphenanthrene-10-oxide,
10-(3,5-di-t-butyl-4-hydroxybenzyl)-9,10-dihydro-9-oxa-10-phosphaphenanthrene-10-oxide and 10-decyloxy-9,10-dihydro-9-oxa-10-phosphaphenanthrene-10-oxide; and the like are exemplified.
These antioxidants can be used alone respectively but may be used in combination of two or more kinds thereof. Particularly in the present invention, a phosphorus-based antioxidant is preferable.

As the light stabilizer, a hindered amine-based light stabilizer, particularly HALS or the like is suitable. HALS is not particularly limited but typical one includes polycondensates of dibutylamine · 1,3,5-triazine · N,N' - bis(2,2,6,6-tetramethyl-4-piperidyl-1,6-hexamethylene diamine with N-(2,2,6,6-tetramethyl-4-piperidyl)butylamine, dimethyl succinate-1-(2-hydroxyethyl)-4-hydroxy-2,2,6,6-tetramethylpiperidine polycondensates, poly[{6-(1,1,3,3-tetramethylbutyl)amino-1,3,5-triazine-2,4-diyl}{(2,2,6,6-tetramethyl-4-pip eridyl)imino}hexamethylene{(2,2,6,6-tetramethyl-4-piperidyl)imino}],
bis(1,2,2,6,6-pentamethyl-4-piperidyl)[[3,5-bis(1,1-dimethylethyl)-4-hydroxyphenyl]meth yl]butylmalonate, bis(2,2,6,6-tetramethyl-4-piperidyl)sebacate, bis(1,2,2,6,6-pentamethyl-4-piperidyl)sebacate,
bis(1-octyloxy-2,2,6,6-tetramethyl-4-piperidyl)sebacate,
2-(3,5-di-t-butyl-4-hydroxybenzyl)-2-n-butylmalonic acid bis(1,2,2,6,6-pentamethyl-4-piperidyl), and the like. A kind of HALS may be used alone or 2 or more kinds thereof may be used in combination.

The resin composition of the present invention is obtained by uniformly mixing the components. The resin composition of the present invention can be easily made into a cured product in the same manner as conventionally known. For example, in the case of an addition reaction-type silicone resin, it is possible that, in mixing a platinum catalyst as an addition reaction catalyst, A component containing an organopolysiloxane having an unsaturated double bond group (alkenyl group), and B component containing an organohydrogenpolysiloxane having a silyl group (Si-H) having a hydrogen atom, said zinc compound is mixed together, or said zinc compound is beforehand mixed in either or both of said A component or said B component before said A component and said B component are uniformly mixed, and then the resulting mixture is applied to a target silver surface followed by heat curing to seal.
On the other hand, in the case of a condensation-type silicone resin, it is possible that, in mixing A component having an organopolysiloxane and a condensation accelerator (for example, organic acid, organic metal and/or the like) and B component containing an organopolysiloxane having a silanol group and/or an alkoxy group, said zinc compound is mixed together, or said zinc compound is beforehand mixed in either or both of said A component or said B component before said A component and said B component are uniformly mixed, and then the resulting mixture is applied to an target silver surface followed by heat curing to seal.

In the sealing resin composition of the present invention, when the resin is the above-described silicone resin, said zinc compound concentration means a concentration based on the resin component (the total amount of the above A component and B component).
In addition, as one of the embodiments of the sealing resin composition of the present invention can include an aspect in which the three of A component, B component and said zinc compound are not mixed until used and they are a set and mixed in use to form a sealing resin composition of the present invention; or an aspect in which said zinc compound is mixed in either or both of A component or B component, and said A and B components are a set without mixing and mixed in use to form a sealing resin composition of the present invention.
The silicone resin to be used in the sealing resin composition of the present invention can be purchased from Toray Dow Corning Silicone Corporation, Shin-Etsu Chemical Co., Ltd., Momentive Performance Materials Inc., Gelest, Inc., and the like.
In the case of an epoxy resin, it is possible that, in mixing A agent containing an epoxy resin containing an epoxy group, an acid anhydride compound as an epoxy-curing agent and/or an amine compound and/or a phenol compound, and if necessary, B agent having a curing accelerator, said zinc compound is mixed together; or said zinc compound is beforehand mixed in either or both of said A component or said B component before said A component and said B component are uniformly mixed, and then the resulting mixture is applied to an target silver surface followed by heat curing to seal. The epoxy resin to be used in the sealing resin composition of the present invention can be available from Japan Epoxy Resin Co. Ltd., Nippon Kayaku Co., Ltd., Daicel Chemical Industries Ltd., New Japan Chemical Co., Ltd., Shikoku Chemicals Corporation and the like.

In the case where these resins are further mixed, when another additive is further mixed, they may be sufficiently mixed to be uniform, according to necessity, using a planetary, a high-speed disperser, an extruder, a kneader, a roll and the like. Tarnish of a silver part can be prevented in that: when the resulting resin composition is liquid, by carrying out a potting, a casting, an impregnation into substrate, or a casting of the resin composition into a mold, followed by curing by heating; or when the resulting resin composition is solid, after melting, by carrying out a casting into a mold, or molding using transfer molding machine, further followed by curing by heating, so that a silver part may be covered. The curing temperature and the period of time are 80 to 200°C and 2 to 10 hours. As the curing method, it is possible to cure at once at a high temperature but it is preferred to raise the temperature stepwise for proceeding the curing reaction. Specifically, curing is initially carried out between 80 and 150°C, and then curing is carried out between 100°C and 200°C. With regard to the curing stage, the temperature is raised preferably at 2 to 8 steps and more preferably at 2 to 4 steps.

Preferable aspects of the silver anti-tarnish agent of the present invention explained hereinbefore will be listed below.
(I) A silver anti-tarnish agent containing at least either a zinc salt or a zinc complex as an effective component.
(II) The silver anti-tarnish agent according to the above-described (I), wherein the zinc salt is a zinc salt of an aliphatic carboxylic acid having a carbon atom number of 6 to 20 or a zinc phosphoric acid C6 to C20 alkyl ester, and the zinc complex is a zinc complex with a carbonyl compound.
(III) The silver anti-tarnish agent according to the above-described (II), wherein the zinc complex with a carbonyl compound is zinc acetylacetonate.
(IV) The silver anti-tarnish agent according to the above-described (II) or (III), wherein the zinc salt of an aliphatic carboxylic acid having a carbon atom number of 6 to 20 is at least one kind selected from the group consisting of zinc 2-ethylhexylate, zinc neodecanoate, zinc laurate, zinc ricinoleate, zinc stearate, zinc undecylenate and zinc naphthenate, and the zinc phosphoric acid C6 to C20 alkyl ester is zinc phosphoric acid 2-ethylhexane ester.
(V) The silver anti-tarnish agent according to any one of the above-described (II) to (IV), wherein the zinc salt of an aliphatic carboxylic acid having a carbon atom number of 6 to 20 is zinc 2-ethylhexylate.
(VI) The silver anti-tarnish agent according to any one of the above-described (II) to (V), wherein a diluent is further contained, and the zinc salt or the zinc complex is contained at a ratio of 0.005 to 10 parts by weight based on 100 parts by weight of the diluent.
(VII) The silver anti-tarnish agent according to the above-described (VI), wherein the content of the zinc salt or the zinc complex based on 100 parts by weight of the diluent is a ratio of 0.005 to 3 parts by weight.
(VIII) The silver anti-tarnish agent according to the above-described (VI) or (VII), wherein the diluent is an organic solvent.
(IX) The silver anti-tarnish agent according to the above-described (VIII), wherein the organic solvent is a ketone solvent.
(X) The silver anti-tarnish agent according to the above-described (VIII) or (IX), wherein the content of the zinc salt or the zinc complex based on 100 parts by weight of the organic solvent is a ratio of 0.005 to 0.5 parts by weight.

(XII) The silver anti-tarnish agent according to the above-described (VI) or (VII), wherein the diluent is a thermosetting resin.
(XIII) The silver anti-tarnish agent according to the above-described (XII), wherein the zinc salt or the zinc complex is contained at a ratio of 0.1 to 2 parts by weight based on 100 parts by weight of the thermosetting resin.
(XIV) The silver anti-tarnish agent according to the above-described (XII) or (XIII), where the thermosetting resin becomes a cured product having a hardness of over 70 as measured by Durometer Type A of JIS K 7215 after curing.
(XV) The silver anti-tarnish agent according to any one of the above-described (XII) to (XIV), wherein the thermosetting resin becomes a cured product having a range of 30 to 70 as measured by Durometer Type D of JIS K 7215 after curing.
(XVI) The silver anti-tarnish agent according to any one of the above-described (XII) to (XV), wherein the thermosetting resin is an addition reaction-type silicone resin.
(XVII) The silver anti-tarnish agent according to the above-described (XVI), wherein said silicone resin is a thermosetting silicone resin containing an organopolysiloxane (A component) and an organohydrogenpolysiloxane (B component) having a C2 or C3 alkenyl group.
(XVIII) The silver anti-tarnish agent according to the above-described (XVII), wherein the above silicone resin contains an organopolysiloxane (A component) and an organohydrogenpolysiloxane (B component) having a C2 or C3 alkenyl group at a ratio that the hydrogen atom bonding to the silicon atom of B component is 0.5 to 4 mol, based on 1 mol of the alkenyl group bonding to the silicon atom of A component in the case where only A component has an alkenyl group; or based on 1 mol of the alkenyl group bonding to the silicon atoms of A component and B component in the case where both A component and B component have an alkenyl group.

(XIX) The silver anti-tarnish agent according to the above-described (XVII) or (XVIII), wherein the above silicone resin has, as an organo group other than the alkenyl group in the organopolysiloxane of A component and the organohydrogenpolysiloxane of B component, both at least one group selected from the group consisting of a phenyl group, a naphthyl group and a cyclohexyl group and a C1 to C4 alkyl group, respectively.
(XX) The silver anti-tarnish agent according to the above-described (XIX), wherein the organo groups other than the above-described alkenyl group is a phenyl group and a methyl group.
(XXI) The silver anti-tarnish agent according to any one of the above-described (XVII) to (XX), wherein the above-described alkenyl group is a vinyl group.
(XXII) The silver anti-tarnish agent according to any one of the above-described (I) to (XXI), which is for a light-emitting diode.
(XXIII) Use of a zinc salt or a zinc complex to manufacture the silver anti-tarnish agent according to any one of the above-described (I) to (XXI).
(XXIV) The use of a zinc salt or a zinc complex according to the above-described (XXIII), the silver anti-tarnish agent is for a light-emitting diode.
(XXV) A silver anti-tarnish method, wherein the silver anti-tarnish agent according to any one of the above-described (I) to (XXII) is applied to a silver surface to form a coating film containing a zinc salt or a zinc complex, followed by drying or curing.
(XXVI) A light-emitting diode having either a dried film or cured coat of the silver anti-tarnish agent according to the above-described (XXII) on the silver surface.
(XXVII) The light-emitting diode according to the above-described (XXVI), wherein the top of a dried or cured film of the above-described silver anti-tarnish agent on the silver surface is sealed with a sealing resin.
(XXVIII) A light-emitting diode, wherein the silver part of the light-emitting diode is directly sealed with the silver anti-tarnish agent according to any one of the above-described (XII) to (XXI).
(XXIX) The silver anti-tarnish agent according to any one of the above-described (XII) to (XXII), wherein the refractive index of the cured product after the thermosetting resin is cured is 1.45 to 1.6.

### Examples

Hereinafter, the present invention will be more specifically explained with Reference Examples, Examples and Test Examples, but the present invention is not limited to these. In this regard," part(s)" means" part(s) by weight" unless otherwise noted below.

### Examples 1 to 3

Silver anti-tarnish agents in the case of coating on a silver surface are specifically shown as Examples 1 to 3.

### Preparation of silver anti-tarnish agent solution:

As an effective component of the silver anti-tarnish agent, Zinc 2-ethylhexylate (manufactured by Hope Chemical Co., LTD., product name: Octope 18% zinc) was dissolved in acetone to give a concentration shown in Table 1 and each silver anti-tarnish agent of the present invention was prepared.

**Table 1**

| Silver anti-tarnish agent | Octope 18% zinc | Acetone | Concentration % |
|---|---|---|---|
| Example 1 | 0.01 g | 100 g | 0.01% |
| Example 2 | 0.05 g | 100 g | 0.05% |
| Example 3 | 0.1 g | 100 g | 0.1% |

### Manufacture of light-emitting diode:

Into a surface mounting-type light-emitting diode package having an opening of φ 5 mm and a wiring with a silver-plated lead frame and being equipped with a chip of a 465 nm central emission wavelength (hereinafter abbreviated as Surface Mounted Devices = SMD), 0.015 g (0.0000015 g of the effective component amount) of a solution from Example 1 was added dropwise, and the resulting light-emitting diode package was left in a dryer of 80°C for 1 hour to manufacture a SMD-type light-emitting diode having a dried film of the silver anti-tarnish agent of the present invention on the silver-plated surface. To the SMD light-emitting diode, an addition reaction-type phenylmethyl silicone resin (hardness as measured by Durometer type D after curing: 40) was poured, and subsequently, said resin was cured by heating at 150°C for 1 hour to manufacture a light-emitting diode sealed with the sealing resin on the dried film of said silver anti-tarnish agent. Similarly, using solutions of Example 2 and Example 3, light-emitting diodes were similarly manufactured.

In this regard, the above-described phenylmethyl silicone resin used for sealing had been obtained by mixing the below-described A and B liquids at a weight ratio of 1:4.
A liquid: Organopolysiloxane containing a catalytic amount (0.1% or less) of a platinum catalyst and having a phenyl group: a methyl group: a vinyl group of 10:12:1 in mole conversion, as an organo group.
B liquid: Organohydrogenpolysiloxane having a phenyl group, a methyl group and a vinyl group as an organo group, where the content ratio of the hydrogen atom in the phenyl group: the methyl group: the vinyl group: the hydrosilyl group is 5.4:5.3:1:1.2 in mole conversion.

Next, in order to observe tarnish resistance of the silver-plated part sealed with the resin in the manufactured light-emitting diode against a sulfur-based gas, sulfurization test (silver tarnish test) shown below was carried out.
In the present invention, resistance to silver tarnish was tested using an aqueous ammonium sulfide solution described below instead of hydrogen sulfide in the viewpoint of safety. The results are shown in Table 2 with the compositions of silver anti-tarnish agents used.

### (Sulfurization test)

The sulfurization test will be specifically mentioned hereinafter.

A glass bottle with an φ 2 cm opening filled with 25 ml of an aqueous ammonium sulfide solution (25% aqueous solution) was placed on the bottom of a 2 L- volume glass sealed container, and the SMD type light-emitting diode obtained above was set in the space of said sealed container and left under an atmosphere of ammonium sulfide gas generated from the aqueous ammonium sulfide solution at room temperature. The degree of silver tarnish on the silver-plated part of said light-emitting diode was observed every hour.
Sealed container: Glass sealed container having a volume of 2 L
Sulfide solution for test: 25 ml of a 25% aqueous ammonium sulfide solution (put in a glass bottle with an φ 2 cm opening and subjected to the test)
Appearance observation: Tarnish of the silver-plated part under a sealant was observed initially (before exposure), and 1 hour, 6 hours and 10 hours after leaving, using a 40-times stereoscopic microscope.
Illuminance test (observing light quantity): In the above-described appearance observation, light quantity was converted into a current by applying 20 mA in Si photodiode light detection apparatus, and change in the light quantity was observed at the current strength. The illuminance retention ratio shows change in light quantity relative to the initial stage.

### Examples 4 to 12 and Comparative Examples 1, 2

In the same manner as in Example 1, each silver anti-tarnish agent solution of Examples 4 to 12 with the composition shown in Table 2 was prepared, and using it, in the same manner as in Example 1, a light-emitting diode sealed with a sealing resin on the dried film of said silver anti-tarnish agent was manufactured. In addition, in the same manner as in Example 1, sulfurization test was carried out and the results thereof are described in Table 2 together with the composition of the silver anti-tarnish agent. The test results of Comparative Examples 1 and 2 not using the silver anti-tarnish agent of the present invention are also shown in Table 2.

In this regard, the addition reaction-type phenylmethyl silicone resin (with a hardness of 60 as measured by Durometer type D after curing) used for sealing in Examples 7 to 12 was obtained by mixing the below-described A and B liquids at a weight ratio of 1:20.
A liquid: Organopolysiloxane containing a platinum catalyst in a catalytic amount (0.1% or less) and having a phenyl group: a methyl group: a vinyl group of 0.4:1:1 in mole conversion, as an organo group.
B liquid: Organohydrogenpolysiloxane having a phenyl group, a methyl group and a vinyl group as an organo group, where the content ratio of the hydrogen atoms in the phenyl group: the methyl group: the vinyl group: the hydrosilyl group (H-Si) is 2:2:1:1 in mole conversion.

Table 2

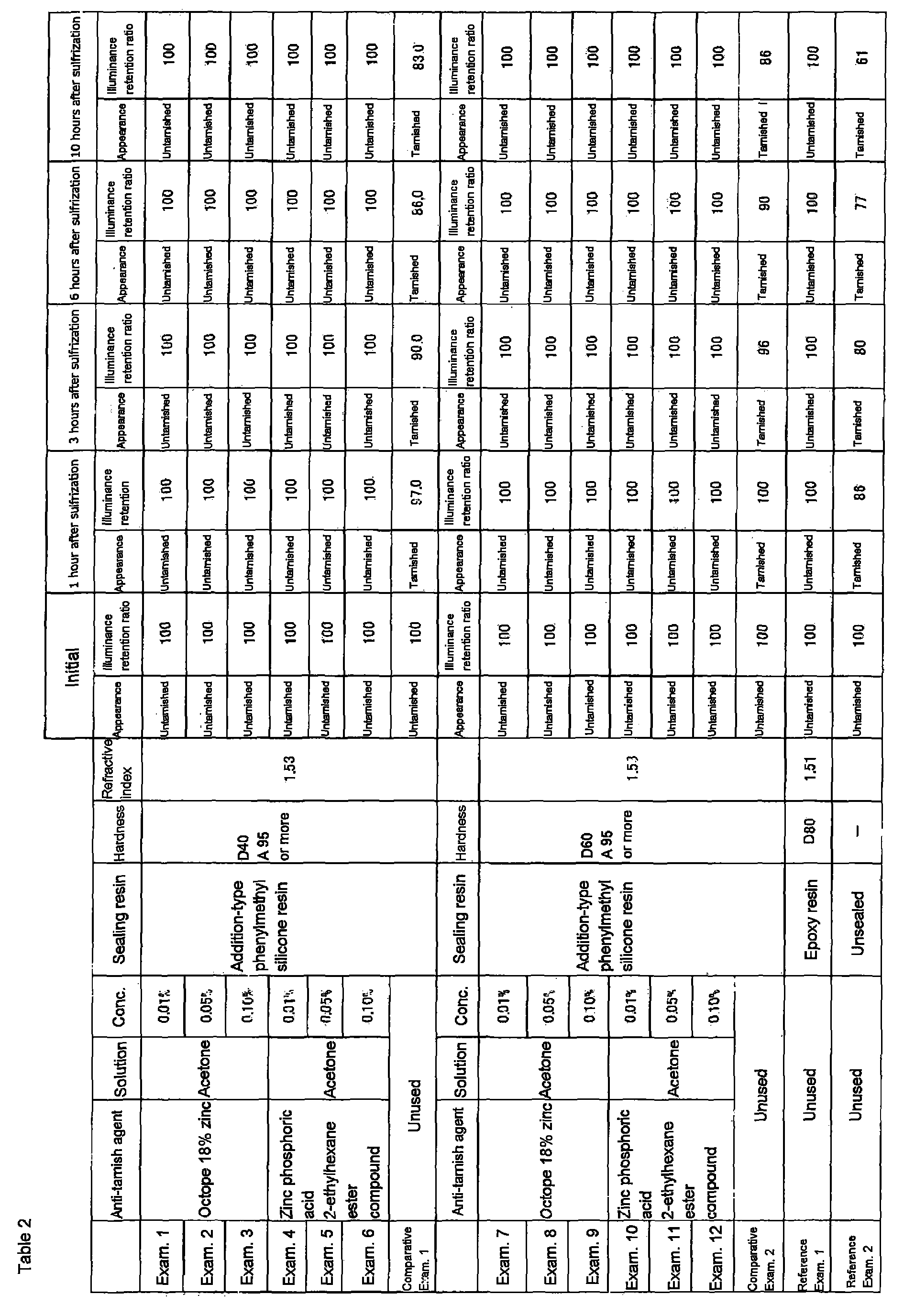

From the results in Table 2, it is confirmed that the sealed light-emitting diodes having a dried film of the silver anti-tarnish agent of the present invention (Examples 1 to 12) can extremely suppress tarnish of silver-plated lead frame, compared with Comparative Examples 1 and 2 not having a dried film of the silver anti-tarnish agent, and further, reduction in illuminance (light quantity) important for a light-emitting diode is not observed.

### Examples 13 and 14

Next, as Examples 13 and 14, each silver anti-tarnish resin composition containing a zinc compound (zinc salt and/or zinc complex) and a sealing resin (one of the aspects of the silver anti-tarnish agent of the present invention) was prepared, and a light-emitting diode was sealed using this and the silver anti-tarnish effect was examined.

### Preparation of silver anti-tarnish resin composition:

To 100 g of an addition reaction-type phenylmethyl silicone resin having a hardness of 40 as measured by Durometer type D after curing which was the same one used in Example 1, Octope zinc 18% was beforehand added and mixed to give a concentration shown in Table 3 and the mixture was used as a sealing material to manufacture a silver anti-tarnish resin composition. The addition concentration is an addition ratio to the silicone resin.

**Table 3**

| | Octope zinc 18% | Phenylmethyl silicone resin | Concentration % |
|---|---|---|---|
| Example 13 | 0.5 g | 100 g | 0.5% |
| Example 14 | 1 g | 100 g | 1% |

### Manufacture of light-emitting diode:

Into a surface mounting-type light-emitting diode package having an opening of Φ 5 mm and a wiring with a silver-plated lead frame and being equipped with a chip of a 465 nm central emission wavelength (hereinafter abbreviated as Surface Mounted Devices = SMD), 0.015 g of the silver anti-tarnish resin composition of the above-described Example 13 was added dropwise and the package was left in a 150°C dryer for 1 hour for heat-curing the phenylmethyl silicone resin to manufacture a light-emitting diode covered with a silver-plated part.
In addition, in the same manner as described above, a light-emitting diode with the silver-plated part covered with a cured product of the silver anti-tarnish resin composition obtained in Example 14 was manufactured.
In order to confirm tarnish resistance of the silver-plated part of the light-emitting diode obtained above, sulfurization test was carried out in the same manner as in Example 1, and its results are shown in Table 4, together with the composition of the silver anti-tarnish agent used. Examples 13 to 14 and Comparative Examples 3 and 4 are shown together in Table 4.

### Examples 15 to 20 and Comparative Examples 3 and 4

In the same manner as in Example 13, silver anti-tarnish resin compositions of Examples 15 to 20 were prepared by formulation shown in Table 4. Using each of those silver anti-tarnish resin compositions, a light-emitting diode with the silver part covered with a cured product of each silver anti-tarnish resin composition was manufactured in the same manner as in Example 13. In order to confirm tarnish resistance of the silver-plated part of the light-emitting diode obtained above, sulfurization test was carried out in the same manner as in Example 1, and its results are shown in Table 4, together with the composition of the silver anti-tarnish agent used.
In addition, the results of Comparative Examples 3 and 4 using the same resin composition as Examples of the present invention except for not containing the silver anti-tarnish agent of the present invention are also shown in Table 4.

Table 4

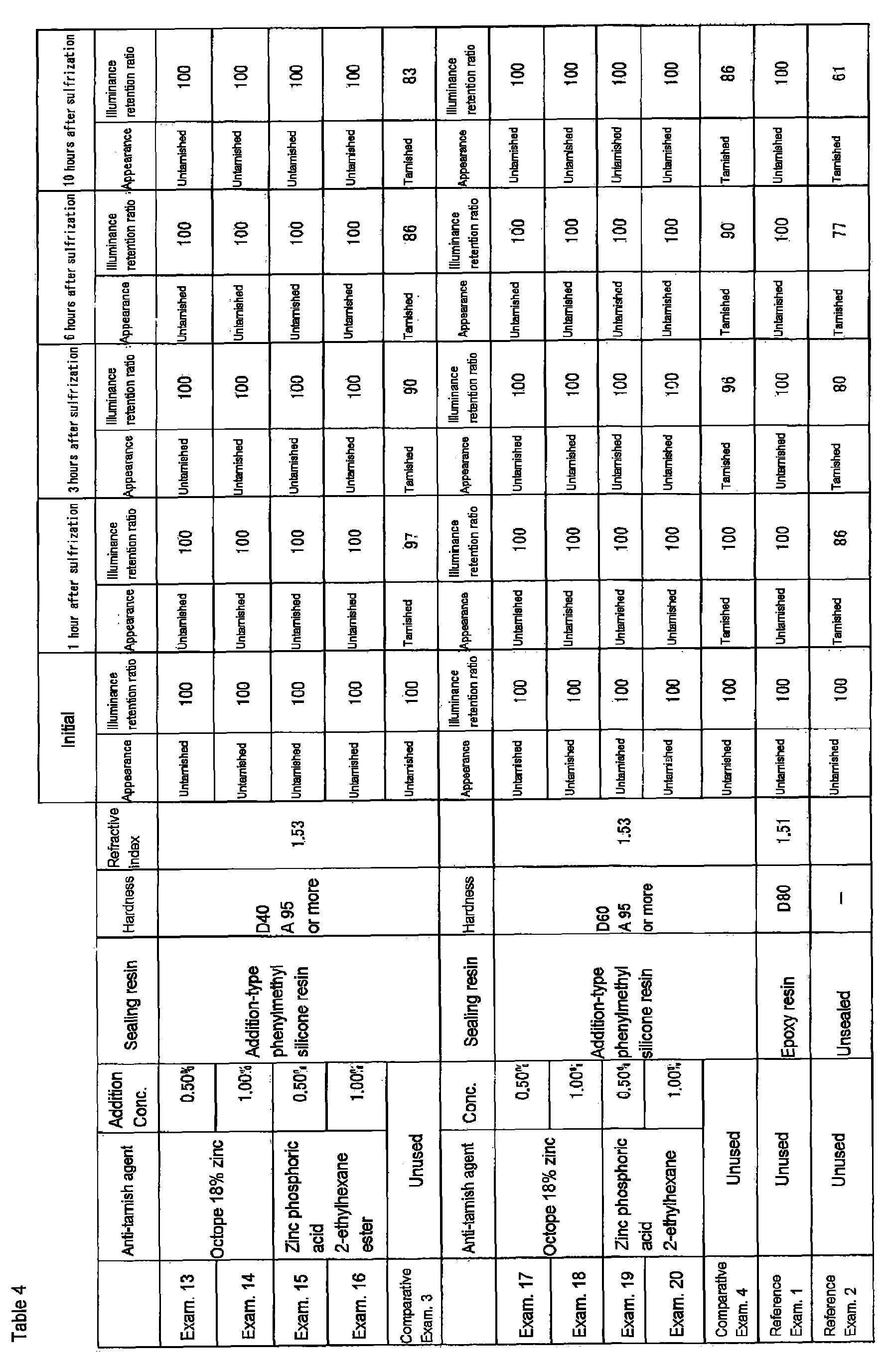

From the results in Table 4, it is confirmed that the silver anti-tarnish resin compositions (Examples 13 to 20) of the present invention suppress tarnish of the silver-plated lead frame, compared with Comparative Example 3 and 4, and reduction in illuminance (light quantity) important for a light-emitting diode is not observed.

The raw materials used in Table 2 and Table 4, the use method and the test will be explained.
· Octope^{RTM} 18% zinc: Zinc 2-ethylhexylate (effective component 100%) (manufactured by Hope Chemical Co., LTD.).
· Zinc phosphoric acid 2-ethylhexane ester compound: Propylene glycol solution containing a zinc salt of 2-ethylhexane ester of phosphoric acid as a zinc salt and/or a zinc complex (mixture of phosphoric acid: monoester body: diester body: triester body of 3.5:68.2:26.5:1.8, which is however not an accurate weight ratio because the analysis was carried out after trimethylsilylation treatment resulting in different sensitivity. Phosphorus: Zinc = 1.7:1, measured by ICP emission spectral analysis, effective concentration of 75 to 78% by weight in accordance with JIS K 0166) (which can be manufactured in accordance with National Publication of International Patent Application No. 2003-51495).
· Addition-type and heat curing-type Phenylmethyl silicone resin having a hardness of 40 as measured by Durometer type D: The same silicone resin as used in Example 1 was used, where the hardness after curing becomes 40 by heat curing.
· Addition-type and heat curing-type phenylmethyl silicone resin having a hardness of 60 as measured by Durometer type D: The same silicone resin as used in Example 7 was used, where the hardness after curing becomes 60 by heat curing.

### (Hardness test)

Type D hardness: Measured by Durometer type D in accordance with JIS K 7215 " durometer hardness test method for plastics" .
Refractive index: Refractive index measuring device of prism coupler system, use wavelength: 633 nm (manufactured by Metricon Corporation, model: 2010 type).

### Examples 21 and 22 and Comparative Example 5

In the same manner as in Example 13 except that an addition reaction-type phenylmethyl silicone resin (abbreviated to adPMSi resin) having a hardness of 30 as measured by Durometer - type D (hardness of 78 as measured by Durometer - type A) after curing was used instead of the addition reaction-type phenylmethyl silicone resin in Example 13, a silver anti-tarnish resin composition of the present invention was prepared at the concentration (concentration of Zinc 2-ethylhexylate to silicone resin) shown in Table 5, and in the same manner as in Example 13, each silver anti-tarnish resin composition of Examples 21 and 22 was obtained. In addition, in the same manner as in Example 13, a light-emitting diode with the silver-plated part covered with a cured product of each silver anti-tarnish resin composition obtained in Examples 21 and 22 was manufactured. In order to confirm tarnish resistance of the silver-plated part of the obtained light-emitting diode, sulfurization test was carried out in the same manner as in Example 1. The results are shown in Table 5, together with the composition of the silver anti-tarnish agent and the results of Comparative Example 5 using the same resin composition as in Example 21 except for not mixing Zinc 2-ethylhexylate.
In this regard, the above-described phenylmethyl silicone resin used for sealing was obtained by mixing the below-described A and B liquids at a weight ratio of 1:3.
A liquid: Organopolysiloxane containing a platinum catalyst in a catalytic amount (0.1% or less) and a phenyl group: a methyl group: a vinyl group of 28:31:1 in mole conversion, as an organo group.
B liquid: Organohydrogenpolysiloxane having a phenyl group, a methyl group and a vinyl group as an organo group where the content ratio of the hydrogen atoms in phenyl group: the methyl group: the vinyl group: the hydrosilyl group is 5.2:5.2:1:1.2 in mole conversion.

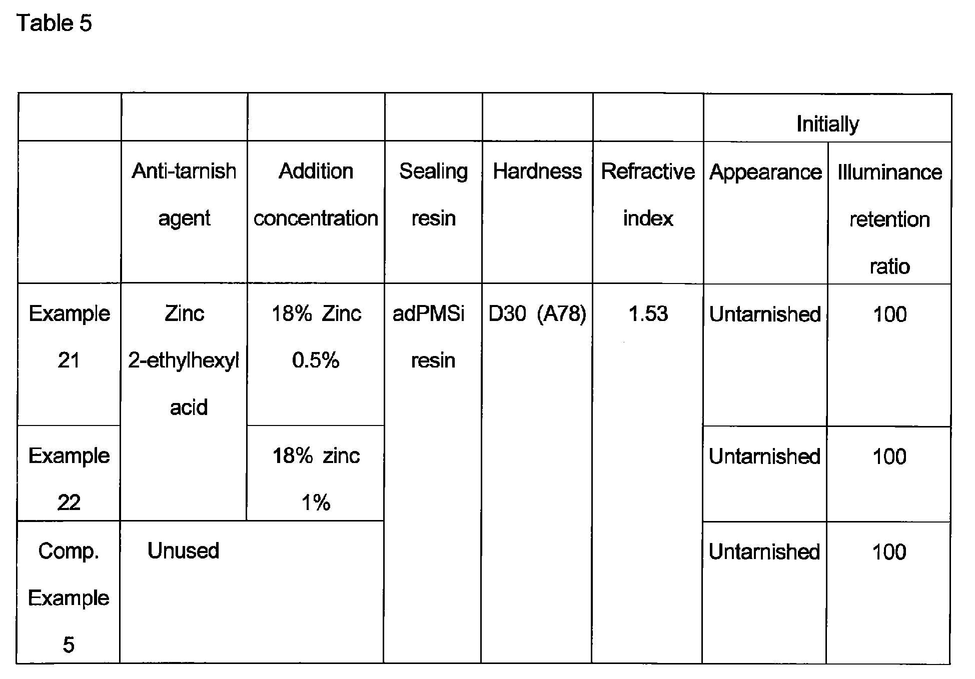

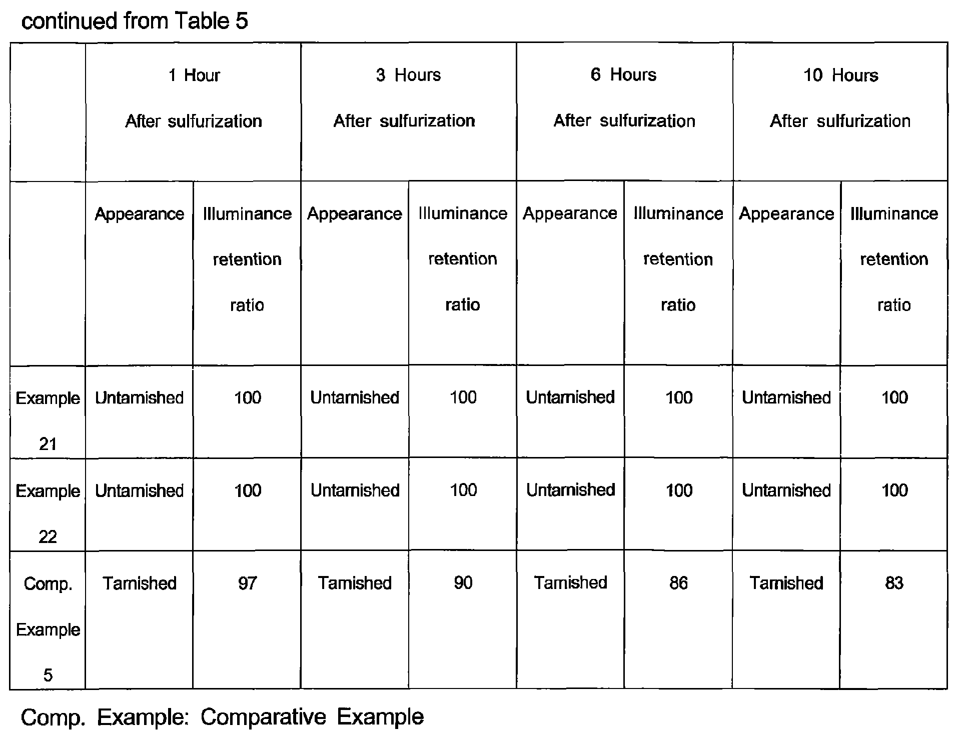

### Example 23

In the same manner as in Example 21 except that zinc stearate was used instead of Zinc 2-ethylhexylate (Octope 18% zinc) in Example 21, a silver anti-tarnish resin composition of the present invention was prepared by adding zinc stearate at a concentration of 0.5% (outer percentage) to the silicone resin, and in the same manner as in Example 13, a light-emitting diode with the silver-plated part covered with a cured product of said silver anti-tarnish resin composition was manufactured. In order to confirm tarnish resistance of the silver-plated part of the obtained light-emitting diode, sulfurization test was carried out in the same manner in Example 1. The results are shown in Table 6, together with the composition of the silver anti-tarnish agent and the results of Comparative Example 6 using the same resin composition as in Example 23 except for not mixing Zinc 2-ethylhexylate.

**Table 6**

| | | | | | | Initial | 1 Hour after sulfurization | 3 Hours after sulfurization | 6 Hours after sulfurization | 10 Hours after sulfurizati on |
|---|---|---|---|---|---|---|---|---|---|---|
| | Anti-tarnish agent | Addition con. | Sealing resin | Hardness | Refractive index | app. | App. | App. | App. | App. |
| Ex. 23 | Zinc stearate | Zinc stearate 0.5% | adPMsi resin | D30 A78 | 1.53 | Un-t | Un-t | Un-t | Un-t | Un-t |
| Com. Ex. 6 | Unused | | | | | Un-t | Tarnished | Tarnished | Tarnished | Tarnished |

| | | | | | | | | | | |
|---|---|---|---|---|---|---|---|---|---|---|
| Addition Con.: Addition concentration App.: Appearance Un-t: Untarnished | | | | | | | | | | |

### LED lighting test

For Examples 1 to 12, each light-emitting diode manufactured in the same manner as in Example 1 to 12 was used for LED lighting test.
In addition, each LED package for LED lighting test using each silver anti-tarnish resin composition of Examples 13 to 20 was manufactured as described below.
Each silver anti-tarnish resin composition obtained in Examples 13 to 20 was filled into a syringe and cast into a surface mounting-type LED package equipped with a chip of a central emission wave of 465 nm and having an external diameter of 5 mm square, using a precise discharge device. The casting was put into a heating oven, followed by curing treatment at 150°C for 1 hour to manufacture an LED package.

An LED package using the epoxy resin of Reference Example 1 was manufactured in the same manner as described above except that said epoxy resin was used instead of the silver anti-tarnish resin composition of the present invention and that curing was carried out at 120°C for 1 hour and further at 150°C for 3 hours. In this regard, as said epoxy resin, an epoxy resin composition was used which had been obtained by mixing 100 parts of ERL-4221 manufactured by Dow Corning, 110 parts of MH-700G manufactured by New Japan Chemical Co., Ltd. as a curing agent, and 0.1 part of trimethyl cetyl ammonium hydroxyde as a curing accelerator.
The LED of each LED package obtained above was turned on and the illuminance retention ratio after 200 hours was measured.
In this regard, the LED lightening conditions were as follows.
LED lightening conditions:
LED chip: Central emission wavelength of 465 nm
LED lightening conditions: Lightening at a constant current mode of 60 mA.
LED lightning environment: Lightening in a heating and humidifying apparatus at 85°C and 85%.
Illuminance retention ratio: (Illuminance 200 hours after lightening/Initial illuminance) x 100 (unit: %).

As evaluation criteria, when the illuminance retention ratio of 80% or more is evaluated as ○, that of 70 to 80% is evaluated as Δ and that of 70% or less is evaluated as ×, and the evaluation results are as follows. In this regard, when LED chip surface was colored, × is marked.
Examples 1 to 20: O (all had a illuminance retention ratio of 95% or more)
Reference Example 1: × (it had a illuminance retention ratio of 58%, also coloring into brown was observed on the LED chip)
As described above, the epoxy resin given as Reference Example has a function of preventing silver tarnish but its durability as LED is inferior.

### Industrial Applicability

According to the present invention, it is possible to protect a silver plate even under a harsh circumstance of exposing directly to a sulfur-based gas and to dramatically improve the durability of a light-emitting diode.

## Claims

1. Use of a zinc salt or a zinc complex for manufacturing a silver anti-tarnish agent containing at least either a zinc salt or a zinc complex as an effective component.

2. The use according to Claim 1, wherein the silver anti-tarnish agent is a silver anti-tarnish agent for a light-emitting diode.

3. The use according to Claim 2, wherein the silver anti-tarnish agent is a silver anti-tarnish agent containing at least one kind selected from the group consisting of a carboxylic acid compound zinc salt having a carbon atom number of 3 to 20, a phosphoric acid zinc salt, a phosphate ester zinc salt and a carbonyl compound zinc complex, as an effective component.

4. The use according to Claim 2, wherein the silver anti-tarnish agent is a silver anti-tarnish agent containing an aliphatic carboxylic acid zinc salt having a carbon atom number of 3 to 20 as an effective component.

5. The use according to Claim 4, wherein said aliphatic carboxylic acid zinc salt is a saturated or unsaturated fatty acid zinc salt.

6. The use according to Claim 4, wherein said aliphatic carboxylic acid zinc salt is at least one kind selected from the group consisting of zinc 2-ethylhexylate, zinc neodecanoate, zinc laurate, zinc ricinoleate, zinc stearate, zinc undecylenate and zinc naphthenate.

7. The use according to Claim 4, wherein said aliphatic carboxylic acid zinc salt is a zinc salt of an alicyclic carboxylic acid having at least either a cyclopentane or cyclohexane skeleton.

8. The use according to Claim 2, wherein the silver anti-tarnish agent is a silver anti-tarnish agent containing a zinc salt of a phosphate ester and/or a phosphoric acid as an effective component.

9. The use according to Claim 2, wherein the silver anti-tarnish agent is a silver anti-tarnish agent containing a zinc acetylacetonate complex as an effective component.

10. The use according to Claim 2, wherein the silver anti-tarnish agent further contains a solvent, and contains 0.005 to 1% by weight of at least either a zinc salt or a zinc complex as an effective component in said solvent.

11. A silver anti-tarnish resin composition for a light-emitting diode, which contains at least either a zinc salt or a zinc complex and a sealing resin, said at least either a zinc salt or a zinc complex being contained in an amount of 0.05 to 10 parts by weight based on 100 parts by weight of said resin.

12. The silver anti-tarnish resin composition according to Claim 11, wherein a cured product of the resin composition has a hardness of over 70 as measured by Durometer Type A of JIS K 7215.

13. The silver anti-tarnish resin composition according to Claim 11, wherein the cured product of the resin composition has a refractive index of over 1.45.

14. The silver anti-tarnish resin composition according to Claim 11, wherein the sealing resin is a sealing resin containing a silicone skeleton.

15. A silver anti-tarnish method, wherein the silver anti-tarnish agent according to Claim 1 is applied to a silver surface.

16. The silver anti-tarnish method according to Claim 15, the silver surface is a silver surface of a light-emitting diode.

17. The silver anti-tarnish method according to Claim 15, wherein the silver anti-tarnish agent according to Claim 1 further contains a solvent, and contains 0.005 to 1% by weight of at least either a zinc salt or a zinc complex as an effective component in said solvent.

18. A silver anti-tarnish method, wherein the silver anti-tarnish resin composition according to Claim 11 is applied to a silver surface of a light-emitting diode.

19. A light-emitting diode having, on the silver surface, a dried film or a cured product coat of a silver anti-tarnish agent containing at least either a zinc salt or a zinc complex.

20. The light-emitting diode according to Claim 19, which is sealed with a sealing resin on the dried film or the cured product coat of the silver anti-tarnish agent.

21. A light-emitting diode having a silver surface sealed with the silver anti-tarnish resin composition according to Claim 11.

22. The light-emitting diode according to Claim 19 or 20, the sealing resin is a silicone resin which is curable by addition reaction, and after curing forms, a cured product having a hardness of over 70 as measured by Durometer Type A of JIS K 7215 after curing.

23. A silver anti-tarnish agent containing at least either a zinc salt or a zinc complex as an effective component, said effective component being contained in a ratio of 0.005 to 1 part by weight based on 100 parts by weight of a diluent.

24. The silver anti-tarnish agent according to Claim 23, wherein the diluent is an organic solvent.

25. The silver anti-tarnish agent according to Claim 23, wherein the diluent is a silicone resin.
